# EUROPEAN PATENT SPECIFICATION

(11) **EP 4 400 854 B1**
(45) Date of publication and mention of the grant of the patent: **08.07.2026**
(21) Application number: 23781143.5
(22) Date of filing: 27.01.2023
(51) Int. Cl.: G01R 31/367, G01R 31/392, G01R 31/3842, G01R 19/00, G01R 19/165, G06N 3/08, G01R 31/382

(54) **METHOD AND SYSTEM FOR BATTERY ABNORMALITY DETECTION THROUGH ARTIFICIAL NEURAL NETWORK BATTERY MODEL BASED ON FIELD DATA**
VERFAHREN UND SYSTEM ZUR ERKENNUNG VON BATTERIEANOMALIEN DURCH EIN BATTERIEMODELL EINES KÜNSTLICHEN NEURONALEN NETZES AUF BASIS VON FELDDATEN
PROCÉDÉ ET SYSTÈME DE DÉTECTION D'ANOMALIE DE BATTERIE PAR L'INTERMÉDIAIRE D'UN MODÈLE DE BATTERIE À RÉSEAU NEURONAL ARTIFICIEL BASÉ SUR DES DONNÉES DE CHAMP

(30) Priority: 30.03.2022 KR 20220039370
(43) Date of publication of application: 17.07.2024
(73) Proprietor: LG Energy Solution, Ltd., Seoul 07335 (KR)
(72) Inventor: YOON, Sung Yul, Daejeon 34122 (KR); KWON, Ki Wook, Daejeon 34122 (KR); LEE, Jeong Bin, Daejeon 34122 (KR)
(74) Representative: Plasseraud IP
(86) International application number: PCT/KR2023/001295
(87) International publication number: WO 2023/191283

(56) References cited:
- JP-A- 2019 168 451
- JP-A- 2020 184 516
- KR-A- 20160 146 032
- KR-A- 20190 022 905
- KR-A- 20220 021 973
- US-A1- 2007 005 276
- US-A1- 2017 184 680
- US-A1- 2020 355 749
- US-B1- 6 285 163

## Description

### TECHNICAL FIELD

The present invention relates to a battery malfunction detection method and system through a battery model. In particular, the present invention relates to a method and system for detecting battery malfunction through an artificial intelligence neural network battery model using field data rather than a conventional chemical/electrical equivalent circuit model in constructing the battery model.

### BACKGROUND ART

Conventionally, general Li-ion battery modeling was implemented using the chemical composition or electrical equivalent circuit. In the case of the corresponding battery modeling, modeling is basically performed based on cell test data including charging/discharging.

However, the internal cell test data is different from that of the actual field environment. In addition, even if an internal cell test is performed under various conditions, it may not be possible to secure sufficient data due to limitations in realistic experiments such as the number of cell samples, module/rack unit, degree of deterioration, temperature conditions, test equipment, and time.

In this regard, patent document 1 proposes a system for receiving measured initial characteristic data of a battery, training an artificial intelligence neural network, predicting long-term characteristic data therefrom, and determining the reliability thereof, and patent document 2 discloses a battery state estimation method in which physical quantity information of a battery is input to a battery training model and estimation information is obtained from the battery training model.

By the way, these conventional technologies are still insufficient to implement a method of estimating the state of the battery based on actual field data and determining whether or not the battery is malfunctioning.

Document US 2020/355749 discloses a secondary battery control system that conducts abnormality detection while predicting various parameters.

Document US 2017/184680 discloses a sensor management system which includes a data collector configured to collect various types of data from a plurality of sensors, and an estimator configured to estimate other types of data based on two or more types of the collected data.

Document US 6 285 163 discloses means for estimating the charged state of a battery, capable of accurately estimating an SOC even though the battery repeats charging/discharging in short cycles.

Related prior art includes the following documents.
Patent Document 1: Korean Laid-open Patent Publication No. 10-2009-0020448
Patent Document 2: Korean Laid-open Patent Publication No. 10-2018-0057226

### DISCLOSURE OF THE INVENTION

### TECHNICAL PROBLEM

In order to solve the problems described above, the present invention is to provide a method and system for detecting malfunction of a battery cell by utilizing field data.

There is also a problem to be solved in utilizing the field data, which is that there are inevitably limitations on types of data collection items and the accuracy thereof is low.

In order to solve this problem, it is intended to provide a battery malfunction detection method and system in which a battery modeling through AI training is implemented in order to model a battery by utilizing various field data and which uses the battery modeling.

### TECHNICAL SOLUTION

In order to solve the problems described above, according to the present invention, there is provided, as a system for detecting malfunctioning behavior of a battery, a battery malfunctioning behavior detection system as defined in the appended claims.

According to the present invention, there is also provided a battery malfunctioning behavior detection method.

### ADVANTAGEOUS EFFECTS

According to the present invention, it is possible to predict battery temperature value and voltage value in real time using battery field data and compare the predicted battery temperature value and voltage value with actual temperature value and voltage value to detect in real-time whether or not the battery operates abnormally.

### BRIEF DESCRIPTION OF THE DRAWINGS

The following drawings attached to this specification are intended to illustrate a preferred embodiment of the present invention, and serve to make further understand the technical idea of the present invention together with the detailed description of the invention described above, and thus the present invention should not be construed as being limited only to the matters described in the drawings.
FIG. 1 is a diagram illustrating an example of respective pieces of field data measured and calculated in the present invention.
FIG. 2 is a diagram illustrating an example of extracting training data by pre-processing field data acquired during a certain section or for a predetermined time, from among the field data of FIG. 1.
FIG. 3 is a diagram illustrating a sequence of a battery malfunctioning behavior detection method according to the present invention.
FIG. 4 illustrates a graph illustrating field data values of cell temperature and prediction values of cell temperature over time.
FIG. 5 is a block diagram of a battery malfunctioning behavior detection system according to the present invention.

### MODE FOR CARRYING OUT THE INVENTION

The present invention trains prediction model using field data to predict voltage and temperature at a next time point. Types of field data used in the present invention are as follows.

### Field data

In the present invention, 'field data' means the following data measured in real time from a battery in operation and the following data calculated therefrom. The field data are time-series data of battery state information calculated during battery operation at predetermined time intervals.

The types of field data used in the present invention are as follows.

### (1) Rack data

The rack data is data of a battery rack. The rack data includes rack current, ambient temperature, and fan on/off information. These are usually measured and calculated by a rack battery management system (BMS).

The rack current can be expressed as Rack.Current, ambient temperature as Ambient. Temp, and fan on/off information as Fan_ON/OFF flag value, and they are measured at predetermined time intervals.

The values of the rack current, ambient (Ambient Temp.), and Fan.ON values of Fan ON/OFF information at time t measured at a predetermined cycle can be expressed as Rack.Current(t), Ambient.Temp(t), Fan.ON(t). In this case, the values of Rack.Current(t) and Ambient.Temp(t) have measured values of appropriate measurement sensors, and Fan.ON(t) can have a value of '1' when the fan is running and '0' when the fan is not running.

For example, when measured at 1-second intervals, the rack current, ambient temperature, and fan on/off information (if the fan is running) at 3 seconds after driving can be respectively expressed as Rack.Current(3), Ambient.Temp(3), and Fan.ON(3).

### (2) Module data

The module data is data of each of a plurality of battery modules included in the battery rack. The module data includes an SOC value of each module, and when there are i modules constituting the battery rack, each module is expressed as Mk (k = 1, 2, 3, ...i), and the SOC value of each module (SOC M) is expressed as SOC.Mk. For example, the SOC value of the second module is expressed as SOC.M2. The module data is usually measured and calculated by a module battery management system (BMS).

Like the rack data, the SOC.Mk value can be measured at predetermined time intervals, and the SOC.Mk value at time t is denoted as SOC.Mk(t).

### (3) Cell data

The cell data is data of each of a plurality of battery cells included in the battery module. The cell data includes a cell voltage value Cell V as a voltage measurement value of each cell, and the cell voltage value is denoted as Cell.V.MkCj (j = 1, 2, 3, ...m), whereas each module is composed of m cells. For example, the cell voltage value of the third cell of the second module is denoted as Cell_V_M2C3. The cell data is usually measured and calculated by a cell battery management system (BMS) or, a module battery management system (BMS) when there is no cell BMS.

The Cell.V.MkCj value can also be measured at predetermined time intervals, and the Cell.V.MkCj value at time t is denoted as Cell.V.MkCj(t).

The cell data may include cell temperature. The cell temperature of j-th cell of the k-th module at time t is denoted as Cell.T.MkCj(t).

### (4) Calculated value

The present invention also uses an SOH value SOH MkCj as one of the calculated values. The SOH value of each cell is calculated by the cell battery management system (BMS), the module battery management system (BMS) or the rack battery management system (BMS), and the SOH of a specific cell is denoted as SOH.MkCj (k = 1, 2, 3, ...m).

The SOH.MkCj value can also be measured at predetermined time intervals, and the SOH.MkCj value at time t is denoted as SOH.MkCj(t).

### 2. Battery malfunctioning behavior detection method

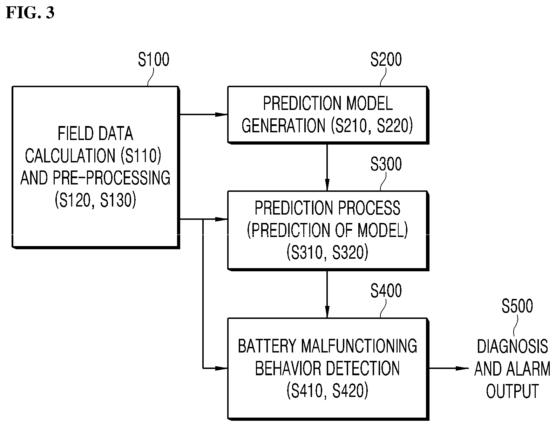

The battery malfunctioning behavior detection method according to the present invention will be described with reference to FIG. 3.

### 2-1. Calculation and pre-processing process of field data (S100)

This process is a procedure for measuring, calculating, and pre-processing the field data described above.

### (1) Field data calculation process (S110)

The field data calculation process is a process of measuring and calculating battery state information data in real-time from a battery in operation.

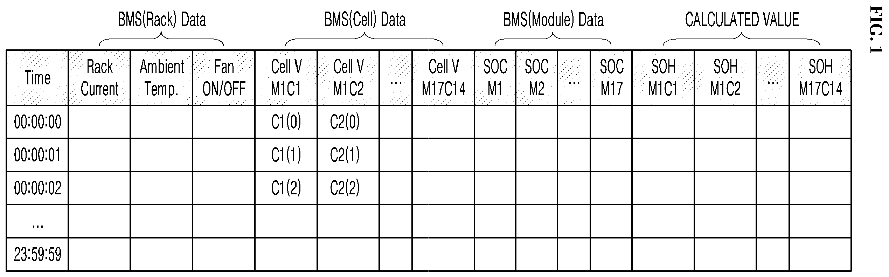

Measurement and calculation of field data is performed in real time from the battery in operation in a predetermined time unit, and FIG. 1 illustrates an example of each field data measured and calculated in the present invention.

The measurement and calculation of field data can be performed in each cell battery management system (BMS), module battery management system (BMS) or rack battery management system (BMS), and the field data is transmitted to the field data calculation unit 100. The field data calculation unit may be configured to be integrated into the rack BMS.

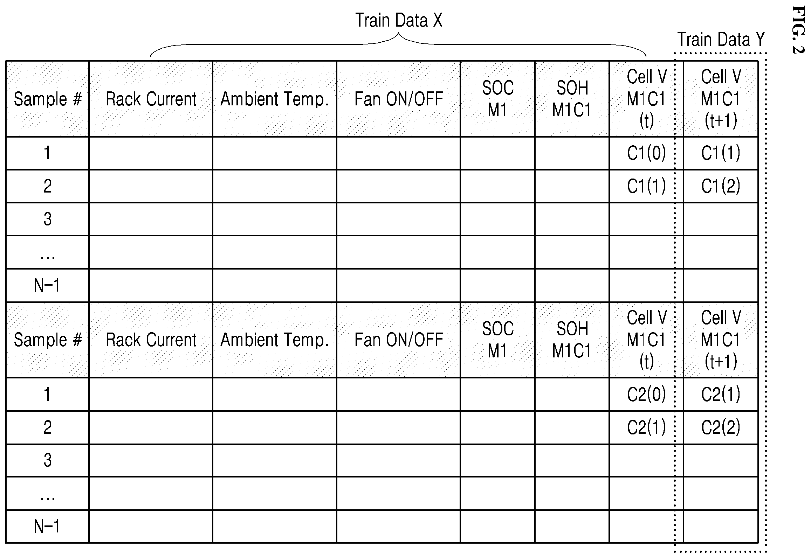

Among the field data shown in FIG. 1 and described above, field data obtained in a certain section or for a predetermined time are pre-processed and extracted as training data as shown in FIG. 2.

### (2)Field data pre-processing process for cell voltage prediction (S120)

The field data pre-processing process for cell voltage prediction is a field data pre-processing process for cell voltage prediction of extracting data for cell voltage prediction from the calculated field data.

In the present invention, a cell voltage is predicted using a cell voltage prediction model that predicts the cell voltage from field data. As data for cell voltage prediction, as shown in FIG. 2, the rack current, ambient temperature, SOC, SOH, and cell voltage of the previous cycle are used as input values.

To this end, in the pre-processing process, Rack.Current(t), Ambient.Temp(t), Fan.ON(t), SOC.Mk(t), SOH.MkCj(t), and Cell.V.MkCj(t) values, which are rack current, ambient temperature, SOC, SOH, cell voltage values, are periodically extracted from the field data calculated in real time at a predetermined cycle. FIG. 2 illustrates a data format for extracting Rack.Current(t), Ambient.Temp(t), Fan.ON(t), SOC.Mk(t) values for each time cycle and SOH_M1C2(t) and Cell_V_M1C2(t) values of cells 1 and 2 of module 1 corresponding to them.

### (3) Field data pre-processing process for cell temperature prediction (S130)

The field data pre-processing for cell temperature prediction is a process of extracting data for predicting the cell temperature from the calculated field data.

In the present invention, a cell temperature is predicted using a cell temperature prediction model that predicts the cell temperature from field data. As data for cell temperature prediction, the cell temperature of the next cycle is predicted using Cell.T.MkCj(t), which is the current temperature value of the cell, ambient temperature Ambient.Temp(t), and Fan.ON(t).

To this end, in the pre-processing process, the Cell.T.MkCj(t), Ambient.Temp(t), and Fan.ON(t) values are periodically extracted from field data calculated in real time at a predetermined cycle.

### 2-2. Prediction model generation process (S200)

### (1) Cell voltage prediction model generation process (S210)

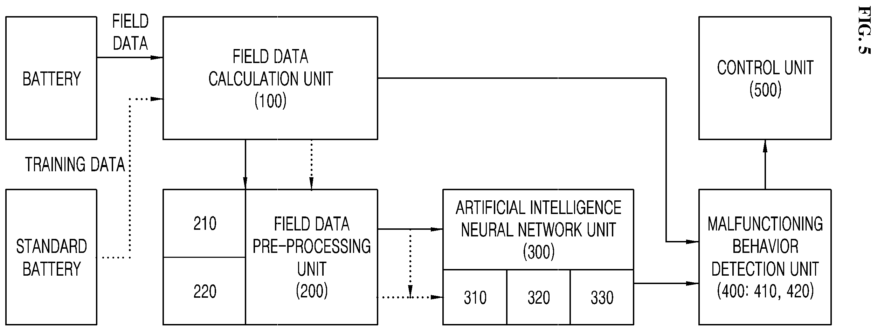

A cell voltage prediction model 210 for cell voltage prediction is generated by conducting supervised learning by inputting Rack.Current(t), Ambient.Temp(t), Fan.ON(t), SOC.Mk(t), SOH.MkCj(t), Cell.V.MkCj(t) to a predetermined artificial intelligence neural network and using the output value thereof as Cell.V.MkCj(t+1). The cell voltage prediction model is generated using a predetermined artificial intelligence neural network. A known artificial intelligence neural network can be used as the artificial intelligence neural network, and the artificial intelligence neural network that has been trained with predetermined training data is stored as the cell voltage prediction model 210 of FIG. 5.

As the training data of the cell voltage prediction model 210, the Rack.Current(t), Ambient.Temp(t), Fan.ON(t), SOC.Mk(t), SOH.MkCj(t), Cell.V.MkCj(t) values for a predetermined time section pre-processed through the field data pre-processing process (S120) for cell voltage prediction are used as input values to the neural network and Cell.V.MkCj(t+1), which is the cell voltage measurement value of the next cycle, is used as the output value thereof, and the cell voltage prediction model is generated by conducting supervised learning on the artificial intelligence neural network so that when the Rack.Current(t), Ambient.Temp(t), Fan.ON(t), SOC.Mk(t), SOH.MkCj(t), Cell.V.MkCj(t) values for a predetermined time section are input to the artificial intelligence neural network, the output value becomes Cell.V.MkCj(t+1), which is the cell voltage measurement value of the next cycle.

The artificial intelligence neural network trained in this way is stored as the cell voltage prediction model 210, which receives the Rack.Current(t), Ambient.Temp(t), Fan.ON(t), SOC.Mk(t), SOH.MkCj(t), Cell.V.MkCj(t) values, and calculates Cell.V_{predic.}MkCj(t+1), which is the cell voltage prediction value of the next cycle.

The Rack.Current(t), Ambient. Temp(t), Fan.ON(t), SOC.Mk(t), SOH.MkCj(t), Cell.V.MkCj(t), Cell.V.MkCj( t+1) values, which are the training data used in the cell voltage prediction model generation process, may be field data measured at a different time from data used in a cell voltage prediction process (S310) below, and may be sample data obtained before battery operation or through operation of sample batteries.

In another embodiment, the cell voltage prediction model may be generated by using Rack.Current(t), Ambient.Temp(t), Fan.ON(t), SOC.Mk(t), SOH.MkCj(t), Cell.V.MkCj(t), Cell.V.MkCj( t+1) for a predetermined time section as training data of the cell voltage prediction model 210, not field data.

That is, the cell voltage prediction model is generated by being trained using data corresponding values for predicting cell voltage calculated from a standard battery rather than a battery in operation for which the field data is calculated, as training data. Thereafter, the cell voltage prediction model receives data for predicting the cell voltage from the battery in operation and outputs a prediction value of the cell voltage of the next cycle.

### (2) Cell temperature prediction model generation process (S220)

In the present invention, a cell temperature prediction model is also included. The cell temperature prediction model 220 for cell temperature prediction is also generated in the same manner as the cell voltage prediction model generation process, using the pre-processed data as training data. That is, supervised learning is conducted by periodically inputting Cell.T.MkCj(t), Ambient.Temp(t), Fan.ON(t) values to a predetermined artificial intelligence neural network, and using the output value thereof as Cell.T.MkCj(t+ 1). The cell temperature prediction model is generated by conducting supervised learning on the artificial intelligence neural network so that Cell.T.MkCj(t), Ambient.Temp(t), Fan.ON(t) values are periodically input for a predetermined time as input data of artificial intelligence neural network and the output value becomes Cell.T.MkCj(t+1), which is the cell temperature measurement value of the next cycle.

The artificial intelligence neural network trained in this way is stored as the cell temperature prediction model 220, which receives the Cell.T.MkCj(t), Ambient.Temp(t), Fan.ON(t) values and calculates Cell.T_{predic}.MkCj(t+1), which is the cell temperature prediction value of the next cycle.

The Cell.T.MkCj(t), Ambient.Temp(t), Fan.ON(t), Cell.T.MkCj(t+1) values, which are the training data used in the cell temperature prediction model generation process, may be field data measured at a different time from data used in the cell temperature prediction process (S320) below, and may be sample data obtained before battery operation or through operation of sample batteries.

In another embodiment, the cell temperature prediction model may be generated by using the Cell.T.MkCj(t), Ambient.Temp(t), Fan.ON(t), Cell.T.MkCj(t+1) values for a predetermined time section calculated using a standard battery in a laboratory as training data, not field data.

That is, the cell temperature prediction model 220 is generated by being trained using data corresponding values for predicting cell temperature calculated from the standard battery rather than a battery in operation for which the field data is calculated as training data, and receives data for predicting the cell temperature from the battery in operation and outputs a prediction value of the cell temperature of the next cycle.

### (3) Prediction model update process (S230)

Another embodiment is a process of re-training and updating the cell voltage prediction model and the cell temperature prediction model by adding field data for a predetermined period of a normal operation section of the battery in operation, for which the field data is calculated, as new training data.

In the cell voltage prediction model generation process, the cell voltage prediction model 210 may be updated by inputting the Rack.Current(t), Ambient.Temp(t), Fan.ON(t), SOC.Mk(t), SOH.MkCj(t), Cell.V.MkCj(t), Cell.V.MkCj( t+1) values for a predetermined time calculated while the battery does not exhibit malfunctioning behavior as new training data. In this case, since the training model is updated by applying actual field data, it is possible to obtain a more accurate prediction value for the actual battery disposed in the field.

In the cell temperature prediction model generation process, the cell temperature prediction model 220 may be updated by inputting Cell.T.MkCj(t), Ambient.Temp(t), Fan.ON(t), Cell.T.MkCj(t+1) values for a predetermined time calculated while the battery does not exhibit malfunctioning behavior as new learning data. In this case, since the training model is updated by applying actual field data (S230), it is possible to obtain a more accurate prediction value for the actual battery disposed in the field.

### 2-3. Real-time prediction process (S300)

The real-time prediction process is a procedure for predicting cell voltage and cell temperature using the cell voltage prediction model and cell temperature prediction model for which the training has been completed.

### (1) Cell voltage prediction process (S310)

The cell voltage prediction process is a procedure for inputting Rack.Current(t), Ambient.Temp(t), Fan.ON(t), SOC.Mk(t), SOH.MkCj(t), Cell.V.MkCj(t) values pre-processed and extracted in the field data pre-processing process (S120) for cell voltage prediction to the generated or updated cell voltage prediction model 210 and calculating Cell.V_{predic}.MkCj(t+1), which is a cell voltage prediction value of the next cycle.

### (2) Cell temperature prediction process (S320)

In the cell temperature prediction process, the Cell.T.MkCj(t), Ambient.Temp(t), Fan.ON(t) values extracted in the pre-processing process (S220) are input into the generated or updated cell temperature prediction model 220 and calculating Cell.T_{predic}.MkCj(t+1), which is the cell temperature prediction value of the next cycle.

### 2-4. Battery malfunctioning behavior detection process (S400)

### (1) Cell voltage malfunctioning behavior detection process (S410)

This cell voltage malfunctioning behavior detection process is a process of detecting a case in which the Cell.V_{predic.}MKCj(t+1) value, which is a prediction value output by the cell voltage prediction model 210 through the cell voltage prediction process (S310), is compared with the Cell.V.MkCj(t+1) value of the field data calculated from the battery and a difference greater than or equal to a predetermined reference value occurs. When the difference greater than or equal to the predetermined reference value occurs, a cell voltage malfunctioning behavior detection signal is generated.

### (2) Cell temperature malfunctioning behavior detection process (S420)

This cell temperature malfunctioning behavior detection process is a process of detecting a case in which the Cell.T_{predic}.MkCj(t+1) value, which is a prediction value output by the cell temperature prediction model 220 through the cell temperature prediction process (S320), is compared with the Cell.T.MkCj(t+1) value in field data calculated from the battery and a difference greater than or equal to a predetermined reference value occurs. When the difference greater than or equal to a predetermined reference value occurs, a cell temperature malfunctioning behavior detection signal is generated.

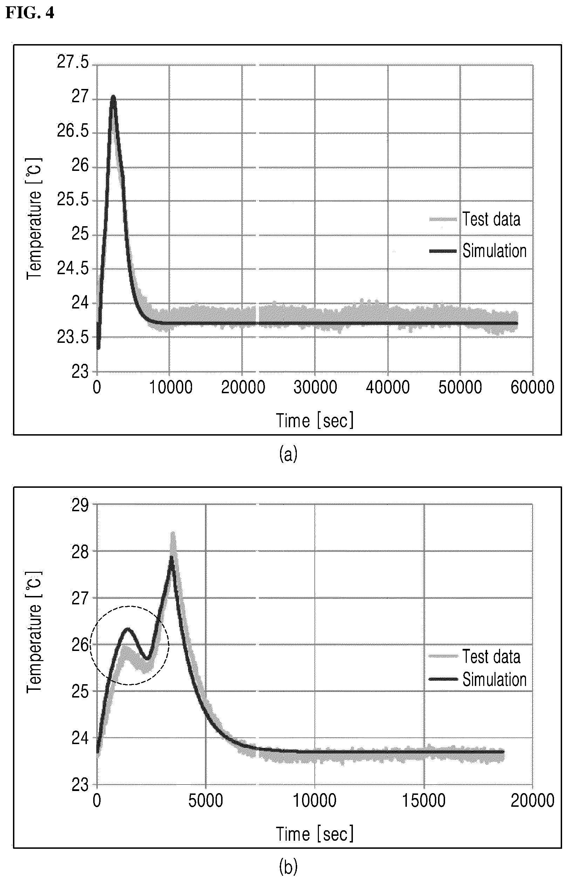

When describing an example of the detection with reference to FIG. 4, the Cell.T.MkCj(t+1) values which are field data are indicated as 'test data' and the Cell.T_{predic}.MkCj(t+1) which are prediction value are indicated as 'simulation'. As illustrated in (a) of FIG. 4, when the deviation greater than or equal to a predetermined reference value does not occur between the field data and the prediction value, it is determined as normal behavior, and, as illustrated in (b) of FIG. 4, when the deviation greater than or equal to the predetermined reference value occurs between the field data and the prediction value, it is determined and detected as battery malfunctioning behavior.

### 2-5. Diagnosis and alarm generation process (S500)

The diagnosis and alarm generation process is a procedure for performing a diagnosis procedure or generating an alarm externally when the difference between the Cell.V_{predic}.MkCj(t+1) value, Cell.Tpredic.MkCj(t+1) values and the Cell.V.MkCj(t+1) value, Cell.T.MkCj(t+1) value, which is greater than or equal to a reference value, occurs.

In the present invention, the diagnostic procedure is not limited to a specially defined procedure, and when the deviation greater than or equal to the reference value occurs more than a predetermined number of times during a predetermined time section, an alarm generation signal may be output or a control signal for blocking a battery charging or discharging operation may be output.

### 3. Battery malfunctioning behavior detection system

Referring to FIG. 5, a battery malfunctioning behavior detection system according to the present invention will be described.

### 3-1. Field data calculation unit 100

The field data calculation unit 100 receives real-time measurement values from the battery in operation, calculates field data values from the received data, and outputs the calculated values. Measurement and calculation of field data may be performed in each cell battery management system (BMS), module battery management system (BMS), or rack battery management system (BMS), and the field data are transmitted to the field data calculation unit 100. The field data calculation unit may be configured to be integrated into the rack BMS. The measurement values received from the battery are values received from respective sensors installed in the battery, and include normal battery state information measurement values. The calculated field data are field data of the present invention described above.

The field data calculation unit transmits the field data to the field data pre-processing unit 200.

### 3-2. Field data pre-processing unit 200

The field data pre-processing unit 200 is configured to include a cell voltage prediction field data pre-processing unit 210 that extracts field data for cell voltage prediction and a cell temperature prediction field data pre-processing unit 220 that extracts field data for cell temperature prediction, from the field data calculated by the field data calculation unit 210, and performs the field data pre-processing process for cell voltage prediction (S120) and the field data pre-processing process for cell temperature prediction (S130).

The field data pre-processing unit 200 transmits training data and field data to the artificial intelligence neural network unit 300.

In this case, the training data, as indicated by the path of the arrow shown by the dotted line in FIG. 5, may be provided to the artificial intelligence neural network unit 300 by calculating data corresponding to each item constituting field data from a standard battery, of which normal quality has been verified in a laboratory, for a predetermined period of time. That is, the cell voltage prediction model 320 constituting the artificial intelligence neural network unit is trained using field data corresponding values for predicting cell voltage calculated from the standard battery as training data, and the cell temperature prediction model 330 may be trained using field data corresponding values for predicting cell temperature calculated from the standard battery as training data.

In another embodiment, a configuration in which the training data is provided to the artificial intelligence neural network unit 300 by extracting field data for a certain period of time as training data during battery operation may be adopted.

Meanwhile, regardless of which of the two types of data is used as training data, the field data pre-processing unit 200 may provide the field data of the battery in the normal operation section as the training data so that the pre-trained artificial intelligence neural networks 320 and 330 are trained.

### 3-3. Artificial intelligence neural network unit 300

### (1) Neural network training unit 310

The neural network training unit 310 receives the training data described above from the field data pre-processing unit 200 and trains the artificial intelligence neural network. The artificial intelligence neural network is trained as the cell voltage prediction model 320 and the cell temperature prediction model 330, and in the the neural network training unit, the prediction models are trained to predict cell voltage and cell temperature, respectively, and stored.

The neural network training unit 310 can also be controlled to retrain the artificial intelligence neural network by adding field data for a predetermined period of the battery normal operation section as new training data at a predetermined cycle or under the control of the control unit 500 so as to update the prediction models 320 and 330.

For example, while the prediction models 320 and 330 are trained and operated with the training data provided from the standard battery and generate prediction values by receiving field data, by re-training the prediction models 320 and 330 by adding field data in a section during which malfunctioning behavior is not detected by the battery malfunctioning behavior detection unit 400 described later, that is, in a normal section, to the training data, the prediction models 320 and 330 are trained to reflect field data generated from the operating state of the actual field battery, which improves the prediction accuracy of the prediction models 320 and 330.

The artificial intelligence neural networks which have been trained with the training data or which have been re-trained and updated by adding field data is stored as the cell voltage prediction model 320 and the cell temperature prediction model 330, respectively.

### (2) Cell voltage prediction model 320

The cell voltage prediction model 320 is a trained artificial intelligence neural network that receives field data for cell voltage prediction from the field data pre-processing unit 200 and predicts cell voltage of the next cycle. The field data for cell voltage prediction may be Rack.Current(t), Ambient.Temp(t), Fan.ON(t), SOC.Mk(t), SOH.MkCj(t), Cell.V.MkCj(t) values, and Cell.V_{predic}.MkCj(t+1), which is a cell voltage prediction value, is calculated by receiving these values.

### (3) Cell temperature prediction model 330

The cell temperature prediction model 330 is a trained artificial intelligence neural network that receives field data for cell temperature prediction from the field data pre-processing unit 200 and predicts the cell temperature of the next cycle. The field data for cell temperature prediction may be Cell.T.MkCj(t), Ambient.Temp(t), Fan.ON(t) values, and Cell.Tpredic.MkCj(t+1), which is a cell temperature prediction value, is calculated by receiving these values.

### 3-4. Battery malfunctioning behavior detection unit 400

The battery malfunctioning behavior detection unit 400 compares prediction values of cell voltage and cell temperature calculated by the cell voltage prediction model 320 and the cell temperature prediction model 330 of the artificial intelligence neural network unit 300 with cell voltage and cell temperature of field data, detects malfunctioning behavior of the battery, and transmits a malfunctioning behavior detection signal to a control unit. The malfunctioning behavior detection signal may include at least one or both of a cell voltage malfunctioning behavior signal and a cell temperature malfunctioning behavior signal, which will be described later.

The battery malfunctioning behavior detection unit 400 receives field data output by the field data calculation unit and the prediction value output by the artificial intelligence neural network unit 300.

### (1) Cell voltage malfunctioning behavior determination unit 410

The cell voltage malfunctioning behavior determination unit 410 compares the Cell.V_{predic}.MkCj(t+1) value described above with the Cell.V.MkCj(t+1) value of the field data, and determines that it is the cell voltage malfunctioning behavior when the deviation is greater than or equal to a predetermined range, and transmits the cell voltage malfunctioning behavior signal to the control unit.

### (2) Cell temperature malfunctioning behavior determination unit 420

The cell temperature malfunctioning behavior determination unit 420 compares the Cell.T_{predic}.MkCj(t+1) value described above with the Cell.T.MkCj(t+1) value of the field data, determines that it is the cell temperature malfunctioning behavior when the deviation is greater than or equal to the predetermined range, and transmits the cell temperature malfunctioning behavior signal to the control unit.

### 3-5. Control unit 500

The control unit 500 receives the malfunctioning behavior detection signal from the malfunctioning behavior detection unit 400 and performs the diagnosis and alarm generation process (S500) described above.

The control unit may be respectively connected to the field data calculation unit, the field data pre-processing unit, the prediction model, and the malfunctioning behavior detection unit to control respective configurations. In another embodiment, all configurations of the field data calculation unit, the field data pre-processing unit, the prediction model, and the malfunctioning behavior detection unit may be physically integrated to be configured as the control unit. In this case, the integrated control unit may be implemented by being directly connected to the rack BMS of the battery or integrated into the rack BMS.

## Claims

1. A battery malfunctioning behavior detection system comprising:
a field data calculation unit (100) configured to receive real-time measurement values from a battery in operation and to calculate and output field data from the real-time measurement values;
a field data pre-processing unit (200) configured to extract first field data for predicting a cell voltage and second field data for predicting a cell temperature from the field data;
an artificial intelligence neural network unit (300) configured to output a prediction value of the cell voltage from the first field data and to output a prediction value of the cell temperature from the second field data; and
a battery malfunctioning behavior detection unit (400) configured to compare the prediction value of the cell voltage and the prediction value of the cell temperature with the first field data and the second field data, respectively and to determine that it has malfunctioning behavior when the deviation is greater than or equal to a predetermined range;
wherein the first field data comprise time-series values of rack current, ambient temperature, fan on-off information, module SOC, cell SOH, and cell voltage for each battery cell and battery module constituting the battery, and the second field data comprise time-series values of cell temperature, ambient temperature, and fan on-off information for each battery cell and battery module constituting the battery;
wherein the artificial intelligence neural network unit (300) is configured to comprise:
a cell voltage prediction model that is trained using field data corresponding values for predicting the cell voltage calculated from a standard battery rather than the battery for which the field data is calculated, as training data, wherein the cell voltage prediction model is configured to receive the first field data for predicting the cell voltage, and to output the prediction value of the cell voltage of the next cycle, and
a cell temperature prediction model that is trained using field data corresponding values for predicting the cell temperature calculated from the standard battery rather than the battery for which the field data is calculated, as training data, wherein the cell temperature model is configured to receive the second field data for predicting the cell temperature and to output the prediction value of the cell temperature of the next cycle;
wherein the artificial intelligence neural network unit (300) further comprises a neural network training unit configured to retrain and update a cell voltage prediction model and a cell temperature prediction model by adding field data of a predetermined period of a normal operation section of the battery as new training data.

2. The system of claim 1,
wherein the artificial intelligence neural network unit (300) is configured to receive the first field data for predicting the cell voltage to output a prediction value of the cell voltage of a next cycle, and to receive the second field data for predicting the cell temperature to output a prediction value of the cell temperature of a next cycle.

3. A battery malfunctioning behavior detection method carried out by the system according to any of claims 1 and 2, the method comprising:
a field data calculation process (S110) of measuring and calculating real-time battery state information data from a battery in operation;
a field data pre-processing process including a field data pre-processing process for cell voltage prediction (S120) of extracting data for cell voltage prediction from calculated field data;
a prediction model update process (S230) of retraining and updating a cell voltage prediction model and a cell temperature prediction model by adding field data of a predetermined period of a normal operation section of the in-operation battery as new training data
a real-time prediction process (S300) including a cell voltage prediction process (S310) of inputting the data for cell voltage prediction into the updated cell voltage prediction model and calculating a cell voltage prediction value of the next cycle; and
a battery malfunctioning behavior detection process (S400) including a cell voltage malfunctioning behavior detection process (S410) of comparing the cell voltage prediction value with a cell voltage value of the field data and generating a cell voltage malfunctioning behavior detection signal when the deviation is greater than or equal to a predetermined range;
wherein the field data pre-processing process further comprises a field data pre-processing process for cell temperature prediction (S130) of extracting data for predicting cell temperature from the calculated field data;
the real-time prediction process (S300) further comprises a cell temperature prediction process (S320) of inputting data for cell temperature prediction into the updated cell temperature prediction model and calculating a cell temperature prediction value of the next cycle;
the battery malfunctioning behavior detection process (S400) further comprises a cell temperature malfunctioning behavior detection process (S420) of comparing the cell temperature prediction value with the cell temperature value of the field data and generating a cell temperature malfunctioning behavior detection signal when the deviation between the cell temperature prediction value and the cell temperature value is greater than or equal to a predetermined range;
the cell voltage prediction model that is trained using data corresponding values for predicting the cell voltage calculated from a standard battery rather than the battery in operation for which the field data is calculated, as training data, and is updated and retrained to receive the data for predicting the cell voltage from the battery in operation, and is configured to output the prediction value of the cell voltage of the next cycle;
the cell temperature prediction model that is trained using data corresponding values for predicting the cell temperature calculated from a standard battery rather than the battery in operation for which the field data is calculated, as training data, and is updated and retrained to receive the data for predicting the cell temperature, and is configured to output the prediction value of the cell temperature of the next cycle;
the data for predicting the cell voltage are time-series values of rack current, ambient temperature, fan on-off information, module SOC, cell SOH, and cell voltage for each battery cell and battery module constituting the battery; and
the data for predicting the cell temperature are time series values of cell temperature, ambient temperature, and fan on/off information for each battery cell and battery module constituting the battery.

## Patentansprüche

1. System zum Erkennen von fehlerhaftem Verhalten einer Batterie, umfassend:
eine Felddatenberechnungseinheit (100), die konfiguriert ist, um Echtzeitmesswerte von einer in Betrieb befindlichen Batterie zu empfangen und Felddaten aus den Echtzeitmesswerten zu berechnen und auszugeben;
eine Felddatenvorverarbeitungseinheit (200), die konfiguriert ist, um erste Felddaten zur Vorhersage einer Zellenspannung und zweite Felddaten zur Vorhersage einer Zellentemperatur aus den Felddaten zu extrahieren;
eine Einheit eines neuronalen Netzwerks für künstliche Intelligenz (300), die konfiguriert ist, um einen Vorhersagewert der Zellenspannung aus den ersten Felddaten auszugeben und einen Vorhersagewert der Zellentemperatur aus den zweiten Felddaten auszugeben; und
eine Einheit zum Erkennen von fehlerhaftem Verhalten einer Batterie (400), die konfiguriert ist, um den Vorhersagewert der Zellenspannung und den Vorhersagewert der Zellentemperatur mit den ersten Felddaten bzw. den zweiten Felddaten zu vergleichen und zu bestimmen, dass ein fehlerhaftes Verhalten vorliegt, wenn die Abweichung größer oder gleich einem vorbestimmten Bereich ist;
wobei die ersten Felddaten Zeitreihenwerte von Rack-Strom, Umgebungstemperatur, Lüfter-Ein-/Aus-Informationen, Modul-SOC, Zellen-SOH und Zellenspannung für jede Batteriezelle und jedes Batteriemodul umfassen, die die Batterie bilden, und die zweiten Felddaten Zeitreihenwerte von Zellentemperatur, Umgebungstemperatur und Lüfter-Ein-/Aus-Informationen für jede Batteriezelle und jedes Batteriemodul umfassen, die die Batterie bilden;
wobei die Einheit eines neuronalen Netzwerks für künstliche Intelligenz (300) konfiguriert ist, um zu umfassen:
ein Zellenspannungsvorhersagemodell, das unter Verwendung von Felddaten, die Werten zur Vorhersage der Zellenspannung entsprechen, die von einer Standardbatterie anstelle der Batterie, für die die Felddaten berechnet werden, berechnet wird, als Trainingsdaten trainiert wird, wobei das Zellenspannungsvorhersagemodell konfiguriert ist, um die ersten Felddaten zur Vorhersage der Zellenspannung zu empfangen und den Vorhersagewert der Zellenspannung des nächsten Zyklus auszugeben, und
ein Zellentemperaturvorhersagemodell, das unter Verwendung von Felddaten, die Werten zur Vorhersage der Zellentemperatur entsprechen, die von der Standardbatterie anstelle der Batterie, für die die Felddaten berechnet werden, berechnet wird, als Trainingsdaten trainiert wird, wobei das Zellentemperaturmodell konfiguriert ist, um die zweiten Felddaten zur Vorhersage der Zellentemperatur zu empfangen und den Vorhersagewert der Zellentemperatur des nächsten Zyklus auszugeben;
wobei die Einheit eines neuronalen Netzwerks für künstliche Intelligenz (300) ferner eine Trainingseinheit eines neuronalen Netzwerks umfasst, die konfiguriert ist, um ein Zellenspannungsvorhersagemodell und ein Zellentemperaturvorhersagemodell durch Hinzufügen von Felddaten eines vorbestimmten Zeitraums eines normalen Betriebsbereichs der Batterie als neue Trainingsdaten neu zu trainieren und zu aktualisieren.

2. System nach Anspruch 1,
wobei die Einheit eines neuronalen Netzwerks für künstliche Intelligenz (300) konfiguriert ist, um die ersten Felddaten zum Vorhersagen der Zellenspannung zu empfangen, um einen Vorhersagewert der Zellenspannung eines nächsten Zyklus auszugeben, und um die zweiten Felddaten zum Vorhersagen der Zellentemperatur zu empfangen, um einen Vorhersagewert der Zellentemperatur eines nächsten Zyklus auszugeben.

3. Verfahren zum Erkennen von fehlerhaftem Verhalten einer Batterie, ausgeführt durch das System nach einem der Ansprüche 1 und 2, wobei das Verfahren umfasst:
einen Felddatenberechnungsprozess (S110) zum Messen und Berechnen von Echtzeit-Batteriezustandsinformationsdaten von einer in Betrieb befindlichen Batterie;
einen Felddatenvorverarbeitungsprozess, der einen Felddatenvorverarbeitungsprozess für die Zellenspannungsvorhersage (S120) zum Extrahieren von Daten für die Zellenspannungsvorhersage aus berechneten Felddaten umfasst;
einen Aktualisierungsprozess für Vorhersagemodelle (S230) zum Neutrainieren und Aktualisieren eines Zellenspannungsvorhersagemodells und eines Zellentemperaturvorhersagemodells durch Hinzufügen von Felddaten eines vorbestimmten Zeitraums eines normalen Betriebsbereichs der in Betrieb befindlichen Batterie als neue Trainingsdaten;
einen Echtzeitvorhersageprozess (S300), der einen Zellenspannungsvorhersageprozess (S310) zum Eingeben der Daten für die Zellenspannungsvorhersage in das aktualisierte Zellenspannungsvorhersagemodell und zum Berechnen eines Zellenspannungsvorhersagewertes des nächsten Zyklus umfasst; und
einen Prozess zum Erkennen von fehlerhaftem Verhalten einer Batterie (S400), der einen Prozess zum Erkennen von fehlerhaftem Verhalten der Zellenspannung (S410) zum Vergleichen des Zellenspannungsvorhersagewertes mit einem Zellenspannungswert der Felddaten und zum Erzeugen eines Erkennungssignals für fehlerhaftes Verhalten der Zellenspannung umfasst, wenn die Abweichung größer oder gleich einem vorbestimmten Bereich ist;
wobei der Felddatenvorverarbeitungsprozess ferner einen Felddatenvorverarbeitungsprozess für die Zellentemperaturvorhersage (S130) zum Extrahieren von Daten zur Vorhersage der Zellentemperatur aus den berechneten Felddaten umfasst;
der Echtzeitvorhersageprozess (S300) ferner einen Zellentemperaturvorhersageprozess (S320) zum Eingeben von Daten für die Zellentemperaturvorhersage in das aktualisierte Zellentemperaturvorhersagemodell und zum Berechnen eines Zellentemperaturvorhersagewertes des nächsten Zyklus umfasst;
der Prozess zum Erkennen von fehlerhaftem Verhalten einer Batterie (S400) ferner einen Prozess zum Erkennen von fehlerhaftem Verhalten der Zellentemperatur (S420) zum Vergleichen des Zellentemperaturvorhersagewertes mit dem Zellentemperaturwert der Felddaten und zum Erzeugen eines Erkennungssignals für fehlerhaftes Verhalten der Zellentemperatur umfasst, wenn die Abweichung zwischen dem Zellentemperaturvorhersagewert und dem Zellentemperaturwert größer oder gleich einem vorbestimmten Bereich ist;
das Zellenspannungsvorhersagemodell, das unter Verwendung von Daten, die Werten zur Vorhersage der Zellenspannung entsprechen, die von einer Standardbatterie anstelle der in Betrieb befindlichen Batterie, für die die Felddaten berechnet werden, berechnet wird, als Trainingsdaten trainiert und aktualisiert und neu trainiert wird, um die Daten zur Vorhersage der Zellenspannung von der in Betrieb befindlichen Batterie zu empfangen, und konfiguriert ist, um den Vorhersagewert der Zellenspannung des nächsten Zyklus auszugeben;
das Zellentemperaturvorhersagemodell, das unter Verwendung von Daten, die Werten zur Vorhersage der Zellentemperatur entsprechen, die von einer Standardbatterie anstelle der in Betrieb befindlichen Batterie, für die die Felddaten berechnet werden, berechnet wird, als Trainingsdaten trainiert und aktualisiert und neu trainiert wird, um die Daten zur Vorhersage der Zellentemperatur zu empfangen, und konfiguriert ist, um den Vorhersagewert der Zellentemperatur des nächsten Zyklus auszugeben;
die Daten zur Vorhersage der Zellenspannung Zeitreihenwerte von Rack-Strom, Umgebungstemperatur, Lüfter-Ein-/Aus-Informationen, Modul-SOC, Zellen-SOH und Zellenspannung für jede Batteriezelle und jedes Batteriemodul sind, die die Batterie bilden; und
die Daten zur Vorhersage der Zellentemperatur Zeitreihenwerte von Zellentemperatur, Umgebungstemperatur und Lüfter-Ein-/Aus-Informationen für jede Batteriezelle und jedes Batteriemodul sind, die die Batterie bilden.

## Revendications

1. Système de détection de comportement de dysfonctionnement de batterie comprenant :
une unité de calcul de données de terrain (100) configurée pour recevoir des valeurs de mesure en temps réel d'une batterie en fonctionnement et pour calculer et délivrer des données de terrain à partir des valeurs de mesure en temps réel ;
une unité de prétraitement de données de terrain (200) configurée pour extraire des premières données de terrain pour prédire une tension de cellule et des deuxièmes données de terrain pour prédire une température de cellule à partir des données de terrain ;
une unité de réseau neuronal d'intelligence artificielle (300) configurée pour délivrer une valeur de prédiction de la tension de cellule à partir des premières données de terrain et pour délivrer une valeur de prédiction de la température de cellule à partir des deuxièmes données de terrain ; et
une unité de détection de comportement de dysfonctionnement de batterie (400) configurée pour comparer la valeur de prédiction de la tension de cellule et la valeur de prédiction de la température de cellule avec les premières données de terrain et les deuxièmes données de terrain, respectivement, et pour déterminer qu'il y a un comportement de dysfonctionnement lorsque l'écart est supérieur ou égal à une plage prédéterminée ;
dans lequel les premières données de terrain comprennent des valeurs de séries temporelles de courant de rack, de température ambiante, d'informations de marche/arrêt du ventilateur, de SOC de module, de SOH de cellule et de tension de cellule pour chaque cellule de batterie et module de batterie constituant la batterie, et les deuxièmes données de terrain comprennent des valeurs de séries temporelles de température de cellule, de température ambiante et d'informations de marche/arrêt du ventilateur pour chaque cellule de batterie et module de batterie constituant la batterie ;
dans lequel l'unité de réseau neuronal d'intelligence artificielle (300) est configurée pour comprendre :
un modèle de prédiction de tension de cellule qui est entraîné en utilisant des valeurs correspondantes de données de terrain pour prédire la tension de cellule calculée à partir d'une batterie standard plutôt que de la batterie pour laquelle les données de terrain sont calculées, en tant que données d'entraînement, dans lequel le modèle de prédiction de tension de cellule est configuré pour recevoir les premières données de terrain pour prédire la tension de cellule, et pour délivrer la valeur de prédiction de la tension de cellule du cycle suivant, et
un modèle de prédiction de température de cellule qui est entraîné en utilisant des valeurs correspondantes de données de terrain pour prédire la température de cellule calculée à partir de la batterie standard plutôt que de la batterie pour laquelle les données de terrain sont calculées, en tant que données d'entraînement, dans lequel le modèle de prédiction de température de cellule est configuré pour recevoir les deuxièmes données de terrain pour prédire la température de cellule et pour délivrer la valeur de prédiction de la température de cellule du cycle suivant ;
dans lequel l'unité de réseau neuronal d'intelligence artificielle (300) comprend en outre une unité d'entraînement de réseau neuronal configurée pour ré-entraîner et mettre à jour un modèle de prédiction de tension de cellule et un modèle de prédiction de température de cellule en ajoutant des données de terrain d'une période prédéterminée d'une section de fonctionnement normal de la batterie en tant que nouvelles données d'entraînement.

2. Le système selon la revendication 1,
dans lequel l'unité de réseau neuronal d'intelligence artificielle (300) est configurée pour recevoir les premières données de terrain pour prédire la tension de cellule afin de délivrer une valeur de prédiction de la tension de cellule d'un cycle suivant, et pour recevoir les deuxièmes données de terrain pour prédire la température de cellule afin de délivrer une valeur de prédiction de la température de cellule d'un cycle suivant.

3. Procédé de détection de comportement de dysfonctionnement de batterie mis en œuvre par le système selon l'une quelconque des revendications 1 et 2, le procédé comprenant :
un processus de calcul de données de terrain (S110) consistant à mesurer et à calculer des données d'informations sur l'état de la batterie en temps réel à partir d'une batterie en fonctionnement;
un processus de prétraitement de données de terrain incluant un processus de prétraitement de données de terrain pour la prédiction de la tension de cellule (S120) consistant à extraire des données pour la prédiction de la tension de cellule à partir des données de terrain calculées ;
un processus de mise à jour de modèle de prédiction (S230) consistant à ré-entraîner et à mettre à jour un modèle de prédiction de tension de cellule et un modèle de prédiction de température de cellule en ajoutant des données de terrain d'une période prédéterminée d'une section de fonctionnement normal de la batterie en fonctionnement en tant que nouvelles données d'entraînement
un processus de prédiction en temps réel (S300) incluant un processus de prédiction de tension de cellule (S310) consistant à entrer les données pour la prédiction de la tension de cellule dans le modèle de prédiction de tension de cellule mis à jour et à calculer une valeur de prédiction de tension de cellule du cycle suivant ; et
un processus de détection de comportement de dysfonctionnement de batterie (S400) incluant un processus de détection de comportement de dysfonctionnement de tension de cellule (S410) consistant à comparer la valeur de prédiction de tension de cellule avec une valeur de tension de cellule des données de terrain et à générer un signal de détection de comportement de dysfonctionnement de tension de cellule lorsque l'écart est supérieur ou égal à une plage prédéterminée ;
dans lequel le processus de prétraitement de données de terrain comprend en outre un processus de prétraitement de données de terrain pour la prédiction de la température de cellule (S130) consistant à extraire des données pour prédire la température de cellule à partir des données de terrain calculées ;
le processus de prédiction en temps réel (S300) comprend en outre un processus de prédiction de température de cellule (S320) consistant à entrer des données pour la prédiction de la température de cellule dans le modèle de prédiction de température de cellule mis à jour et à calculer une valeur de prédiction de température de cellule du cycle suivant;
le processus de détection de comportement de dysfonctionnement de batterie (S400) comprend en outre un processus de détection de comportement de dysfonctionnement de température de cellule (S420) consistant à comparer la valeur de prédiction de température de cellule avec la valeur de température de cellule des données de terrain et à générer un signal de détection de comportement de dysfonctionnement de température de cellule lorsque l'écart entre la valeur de prédiction de température de cellule et la valeur de température de cellule est supérieur ou égal à une plage prédéterminée ;
le modèle de prédiction de tension de cellule qui est entraîné en utilisant des valeurs correspondantes de données pour prédire la tension de cellule calculée à partir d'une batterie standard plutôt que de la batterie en fonctionnement pour laquelle les données de terrain sont calculées, en tant que données d'entraînement, et est mis à jour et ré-entraîné pour recevoir les données pour prédire la tension de cellule de la batterie en fonctionnement, et est configuré pour délivrer la valeur de prédiction de la tension de cellule du cycle suivant ;
le modèle de prédiction de température de cellule qui est entraîné en utilisant des valeurs correspondantes de données pour prédire la température de cellule calculée à partir d'une batterie standard plutôt que de la batterie en fonctionnement pour laquelle les données de terrain sont calculées, en tant que données d'entraînement, et est mis à jour et ré-entraîné pour recevoir les données pour prédire la température de cellule, et est configuré pour délivrer la valeur de prédiction de la température de cellule du cycle suivant ;
les données pour prédire la tension de cellule sont des valeurs de séries temporelles de courant de rack, de température ambiante, d'informations de marche/arrêt du ventilateur, de SOC de module, de SOH de cellule et de tension de cellule pour chaque cellule de batterie et module de batterie constituant la batterie ; et
les données pour prédire la température de cellule sont des valeurs de séries temporelles de température de cellule, de température ambiante et d'informations de marche/arrêt du ventilateur pour chaque cellule de batterie et module de batterie constituant la batterie.
